## Europäisches Patentamt
## European Patent Office
## Office européen des brevets

(11) Publication number: **0 122 776**
**B1**

## (12) EUROPEAN PATENT SPECIFICATION

(45) Date of publication of patent specification: **27.12.90**

(51) Int. Cl.⁵: **H 01 L 21/31**

(21) Application number: **84302493.6**

(22) Date of filing: **12.04.84**

(54) **Dry etching aluminum or aluminum alloy layer.**

(30) Priority: **13.04.83 JP 64719/83**

(43) Date of publication of application:
**24.10.84 Bulletin 84/43**

(45) Publication of the grant of the patent:
**27.12.90 Bulletin 90/52**

(84) Designated Contracting States:
**DE FR GB**

(56) References cited:
**EP-A-0 019 915**
**EP-A-0 023 429**

**EXTENDED ABSTRACTS, vol. 81-2, October 1981, pages 707-709, abstract no. 290, Pennington, New Jersey, US; D.K. RANADIVE et al.: "Multicycle process for aluminum plasma etching"**

(73) Proprietor: **FUJITSU LIMITED**
**1015, Kamikodanaka Nakahara-ku**
**Kawasaki-shi Kanagawa 211 (JP)**

(72) Inventor: **Takada, Tadakazu c/o FUJITSU LIMITED**
**Patent Department 1015 Kamikodanaka Nakahara-ku**
**Kawasaki-shi Kanagawa 211 (JP)**
Inventor: **Shimizu, Katsunori c/o FUJITSU LIMITED**
**Patent Department 1015 Kamikodanaka Nakahara-ku**
**Kawasaki-shi Kanagawa 211 (JP)**

(74) Representative: **Sunderland, James Harry et al HASELTINE LAKE & CO Hazlitt House 28 Southampton Buildings Chancery Lane London WC2A 1AT (GB)**

Courier Press, Leamington Spa, England.

## Description

The present invention relates to a process for fabricating a wiring layer of aluminum or aluminum alloy, particularly to such a process using dry etching of an aluminum or aluminium alloy thin film.

Thin films of aluminum or aluminum alloy (both will be represented by aluminum, in general, hereinafter) have been generally adopted for providing wiring layers of semiconductor devices including ICs (Integrated Circuits) and LSI (Large Scale Integration) circuits.

Recently, in the manufacture of ICs or LSIs, so-called dry etching, especially such etching using reactive gas species, reactive plasma etching or reactive ion etching for example, has become indispensable for the fabrication of circuit lines or lands of micron or submicron order of width and in which side etching is required to be less than a few tenths of a micron when etching through a layer of thickness of around 1 micron.

In dry etching of aluminum film, a gas containing chlorine species is usually employed as etchant because of its higher etching rate for aluminum as compared with other etchant gases containing different reactive species, for example fluorine.

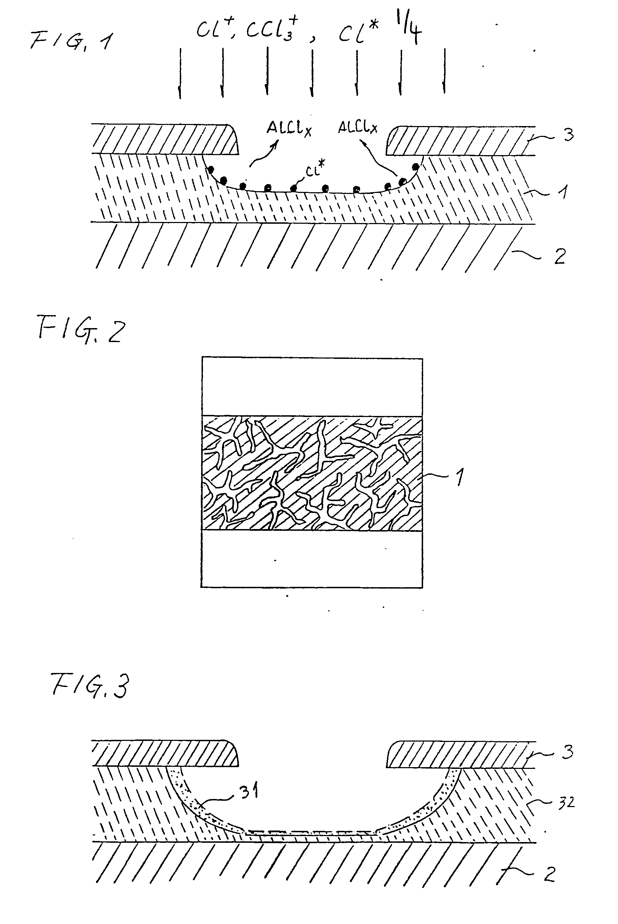

Fig. 1 is a schematic cross-sectional diagram illustrating etching of an aluminum film by active chlorine atoms (chlorine radicals; Cl*).

In Figure 1, an aluminum film 1, formed on an insulating layer 2 on a semiconductor substrate, is selectively masked by a resist mask film 3, such as ordinary photo-resist, for example. At an unmasked portion of the aluminum film 1, incident ions containing chlorine species ($Cl^+$, $CCl_3^+$, etc.) and/or chlorine radicals (Cl*) react with the aluminum film 1, and form volatile aluminum compounds, such as aluminum chloride ($AlCl_x$, where x is considered to be 1, 2, and/or 3). Such aluminum chloride is easily removed from the surface of the aluminum film 1 by thermal agitation or by the bombardment of the incident ions, and etching at a higher speed can be maintained. At the same time, side etching, i.e., etching in lateral direction, takes place in the masked portion of the aluminum film 1 (this side etching is also called under-cutting). It should be noted that the extent of side etching is shown exaggerated in the lateral directions in Fig. 1.

In this prior dry etching technique, highly refined and complicated process control is needed to limit side etching to within the required range mentioned above. Factors to be controlled are pressure and flow rate of etchant gas and the composition of etchant gas, input power for generating plasma, etc. These factors must be tuned individually in each etching system. If etching conditions are not closely controlled, a large amount of side etching can occur; undercutting can extend under a masked portion of the aluminum film so as to completely under-cut the masked portion of the aluminum film before the unmasked portion of the film is etched off. In other words, the difficulty of control of the conditions of the dry etching process causes reduced product yield and reduced operational reliability of product devices, because wiring lines thinned by the side etching can cause burnout failures in devices during operation in the field.

Side etching is believed to result from the absorption of chlorine radicals (Cl*) on the surface of the side wall of the aluminum film. That is, chlorine radicals (Cl*) are electrically neutral and able to move independently of electrical field applied by means of the radio frequency power used for generating etching plasma. Therefore, chlorine radicals can easily diffuse in lateral directions to reach the side wall and attack it.

Another problem involved in the previous dry etching process for aluminum film is that defects, having a vermicular pattern as seen in Fig. 2, develop on the surface of the aluminum film. These defects originate when the aluminum film, after being subject to dry etching using a gas containing chlorine species, is exposed in air. This phenomenon is believed to be due to corrosion of the aluminum film by hydrochloric acid. As described above, aluminum chloride is formed during dry etching and it is adsorbed on the resist mask film 3. Because aluminum choloride is strongly hygroscopic it forms hydrochloric acid (HCl) as soon as it absorbs moisture from air. The hydrochloric acid penetrates the resist mask film 3 and corrodes the surface of the aluminum film 1 under the resist mask film 3. Such corrosion does not occur uniformly all over the surface of the film 1, and the vermicular pattern of Figure 2 arises. Such corrosion decreases the effective cross-section of an aluminum wiring line, and increases its resistivity. This can eventually lead to burnout of the wiring line when the wiring line is fed with electric current.

When an aluminum-silicon alloy film is used for providing a wiring layer, silicon accumulates on the surface of an etched portion of the film. Fig. 3 is a schematic cross-sectional diagram ilustrating a residual polysilicon layer 31 formed on the unmasked portion of an aluminum-silicon alloy film 32 during dry etching. In Fig. 3, reference numerals 2 and 3 designate parts corresponding to similarly referenced parts in Fig. 1. The residual polysilicon layer 31 can cause a short circuit between wiring lines.

This accumulation of polysilicon is due to an etching rate difference between aluminum and silicon with respect to chlorine radicals. The etching rate of silicon by chlorine radicals is less than that of aluminum, and therefore, when polysilicon layer 31 is formed on the surface of aluminum-silicon alloy film, as seen in Fig. 3, the apparent etching rate of the aluminium-silicon alloy film 32 by chlorine radicals decreases. Accordingly, increased time or higher input power is needed for etching off the entire thickness of the aluminium-silicon alloy film 32. This, in turn, leads to an increase in side etching or under-cutting.

EP—A—0 023 429 discloses a dry etching process having the following steps:-

(A) Removing a part of an aluminium alloy (aluminium-copper or aluminium-silicon) layer on a semiconductor chip by reactive ion etching using a mixed gas of $CCl_4$ and $BCl_3$;

(B) Removing copper or silicon residues by exposing the aluminium alloy layer to a plasma of $CF_4$ and 5% $O_2$, after taking the semiconductor chip out of the etching apparatus;

(C) Forming an $AlO_x$ film on the aluminium alloy layer, by washing the surface of the layer in water;

(D) Removing remaining aluminium alloy layer by re-etching by the same method as mentioned at (A) above, after placing the semiconductor chip back in the etching apparatus.

The purpose of step (C) is to prevent or minimise undercutting, i.e. to minimise side etching.

The purpose of step (B), as indicated above, is to remove copper or silicon residues. Where the layer to be etched is an aluminium layer (i.e not an alloy), step (B) is omitted.

According to the present invention there is provided a process for etching a layer of aluminium or aluminium alloy, the process comprising the following successive steps carried out in an etching chamber of an etching apparatus:-

a first dry etching step, for removing a part of the thickness of the layer, using a first gas, comprising chlorine or a chlorine compound, in the etching chamber;

exchanging the first gas in the etching chamber for a second gas which comprises fluorine or fluorine compound gas;

an exposure step, in which a layer surface formed in the first dry etching step is exposed to plasma, generated by discharge in the second gas, supplying fluorine free radicals;

exchanging the second gas in the etching chamber for the first gas or for a further gas which comprises chlorine or a chlorine compound;

a further dry etching step, for removing a further part of the thickness of the layer, using the first gas or the further gas.

An embodiment of the present invention can reduce side etching in respect of a wiring layer of aluminum or aluminum alloy, for a semiconductor device, formed by a dry etching process using a gas containing chlorine species.

An embodiment of the present invention can prevent or reduce corrosion of a wiring layer of aluminum or aluminum alloy, for a semiconductor device, arising following dry etching using a gas containing chlorine species.

An embodiment of the present invention can provide for a high precision patterning of a wiring layer of aluminum or aluminum alloy for a semiconductor device.

An embodiment of the present invention can provide for the production of wiring layers of aluminum or aluminum alloy suitable for semiconductor devices such as ICs and LSI circuits.

In an embodiment of the present invention a plasma exposure step is introduced into a process for fabricating a wiring layer of aluminum or aluminum alloy. The plasma used in the introduced exposure step is generated from discharge in a gas containing fluorine species. This exposure step, in which a substrate carrying aluminum or aluminum alloy wiring material is exposed to the plasma, interrupts a sequence of dry etching steps using a gas containing chlorine species.

Reference is made, by way of example, to the accompanying drawings, in which:-

Fig. 1 is a schematic cross-sectional diagram illustrating etching of an aluminum film by chlorine radicals (Cl*),

Fig. 2 is a schematic illustration of defects having a vermicular pattern developed on the surface of an aluminum film,

Fig. 3 is a schematic cross-sectional diagram illustrating a polysilicon residual layer formed on an unmasked portion of an aluminum-silicon alloy film during dry etching,

Figs. 4(A) and 4(B) are schematic cross-sectional diagrams illustrating substitution of fluorine radicals (F*) for adsorbed chlorine radicals, and the reduction of the side etching, by introduction of a plasma exposure step in accordance with an embodiment of the present invention,

Figs. 5(A) to 5(F) are schematic cross-sectional diagrams illustrating the application of an embodiment of the present invention to the manufacture of a bipolar IC, and

Fig. 6 is a schematic diagram of a dry etching system as employed for carrying out a process embodying the present invention.

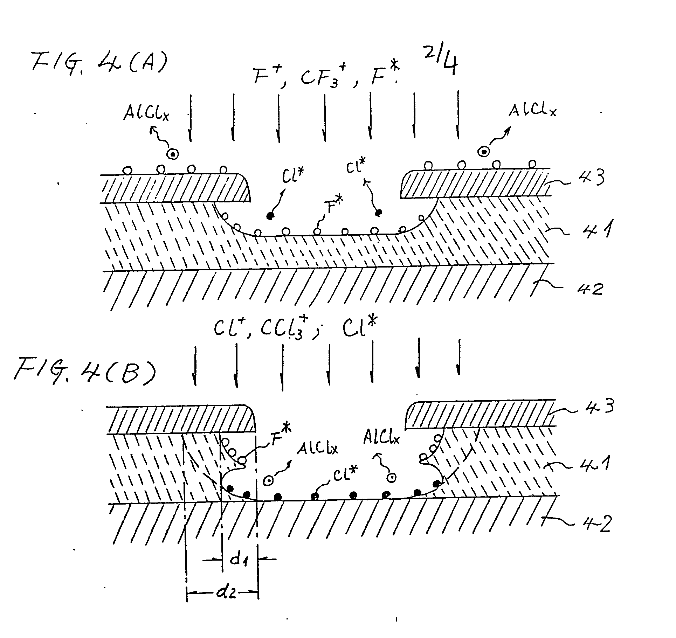

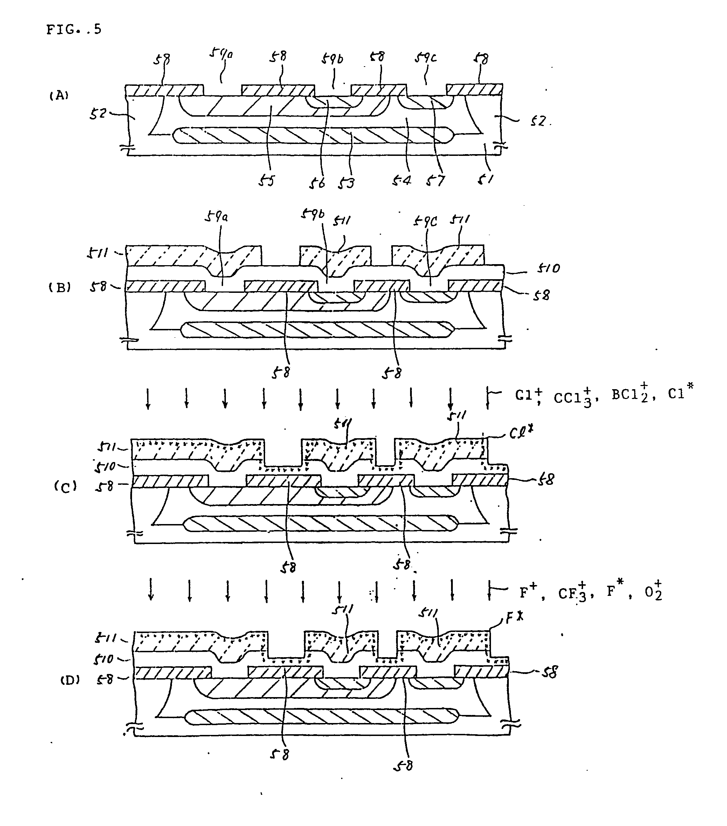

A model explaining the effect of the present invention is illustrated in Figs. 4(A) and 4(B). Fig. 4(A) shows an aluminium film 41, formed on an insulator layer 42, with a masking resist film 43. Fig. 4(A) shows a situation when about half the thickness of an unmasked portion of the aluminum film 41 has been dry-etched by using an etchant gas containing chlorine species; this is referred to as the first dry etching, hereinafter. After the first dry etching, the aluminum film 41 is exposed to a plasma of a gas containing fluorine species. During this plasma exposure process, chlorine radicals (Cl*; solid black dots in the Figure), which have been adsorbed on the surfaces of the unmasked portion of aluminum film 41 and on resist film 43 during the first dry etching process, are replaced by fluorine radicals (F*; unfilled circles). At the same time, aluminum chloride molecules ($AlCl_x$; dotted circles), which have been adsorbed on the surface of the resist film 43, are also removed by the bombardment of incident fluorine ions.

Since fluorine does not form a highly volatile compound such as aluminum chloride upon reaction with the aluminum film 41, reactive etching of the aluminum film 41 during the plasma exposure is very small, and the surface of the aluminum film 41 is densely covered by adsorbed fluorine radicals.

Subsequently to the plasma exposure process, the remaining half of the thickness of the unmasked portion of the aluminum film 41 is etched off completely by dry etching using again the same etchant gas containing chlorine species as used in the first dry etching. This is referred to as the second dry etching hereinafter.

In the second dry etching, as shown in Fig. 4(B) the side wall formed during the first etching is protected by the layer of the adsorbed fluorine radicals from etching by incident chlorine radicals. This is believed to occur because the side wall is protected (shadowed) from ion bombardment and fluorine radicals adsorbed on the side wall are not replaced by incident chlorine radicals, owing to the fact that the binding energy between fluorine and aluminum is larger than that between chlorine and aluminum. On the other hand, at a surface subject to bombardment with chlorine ions, adsorbed fluorine radicals are removed, because the adsorbed radicals are provided with sufficient energy by the ions to achieve this. Thus, etching by chlorine radicals can proceed only at a surface which is subject to chlorine ion bombardment. In this way the remaining half of the thickness of the unmasked portion of the aluminum film is etched off by chlorine radical etchant.

As the chlorine ion bombardment is anisotropic, the second dry etching is initiated to delineate the pattern defined by the resist film 43. As the second dry etching proceeds through the remaining half of the thickness of the aluminum film 41, effectively a new side etching begins in the remaining half thickness of the aluminum film 41, as can be seen in Fig. 4(B). The conditions for side etching in the second dry etching are very similar to those which arose in the first dry etching, and the side etching takes place in a region beneath a surface where masking by a layer of adsorbed fluorine radicals is maintained.

It is easily understood that the amount of the side etching (the maximum depth of undercut) in each of the first and the second dry etchings is less than that in the previous dry etching process illustrated in Fig. 1, which is not interrupted by a plasma exposure step. That is, when plasma exposure is carried out after about a half of the thickness of the aluminum film 41 has been etched off, the amount of the side etching ($d_1$) is about half of that arising in the previous dry etching ($d_2$), as shown in Fig. 4(B). In the Fig. 4(B) the broken line curves indicate the side etch profile achieved with the previous dry etching process of Fig. 1.

If plasma exposure steps were carried out after first one third then two thirds of the thickness of the aluminium film had been etched off, the amount of side etching would by only about one third of that arising in the dry etching process of Fig. 1.

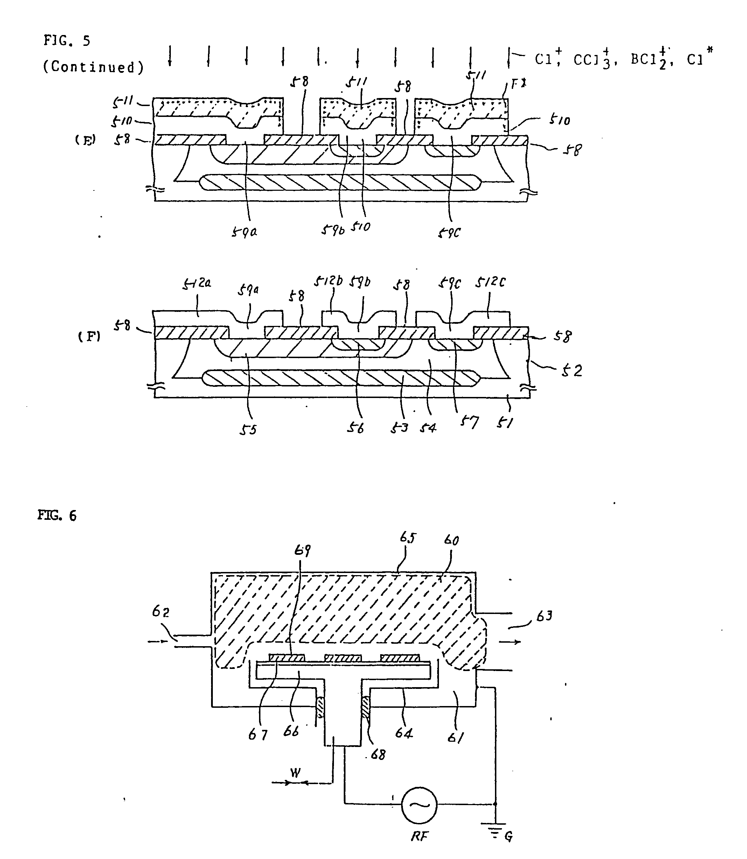

Details of an application of an embodiment of the present invention are described below with reference to Figs. 5(A) to 5(F), which are schematic cross-sectional views, and Fig. 6, which is a schematic diagram of a reactive ion etching system used to put the embodiment of the invention into effect.

Figs. 5(A) to 5(F) illustrate the production of a bipolar IC as an example. To apply an embodiment of the invention to the fabrication of a wiring layer in the bipolar IC, a semiconductor substrate having functional elements as shown in Fig. 5(A) is prepared using conventional manufacturing processes. 51 is a silicon substrate, 52 an isolation region, 53 a buried diffusion layer, 54 a collector region, 55 a base region, 56 an emitter region, 57 a collector contact region, 58 a silicon dioxide ($SiO_2$) insulating layer, and 59a, 59b and 59c are electrode contact holes.

On the substrate of Fig. 5(A), an aluminum film 510 of about 1 micron thickness is formed, as shown in Fig. 5(B), by using conventional vacuum deposition or sputtering technique, then a resist mask film 511 is formed on the aluminum film 510 by use of conventional photoprocesses. The resist mask 511 may be either a negative type or a positive type.

The substrate is then placed in the reactive ion etching system, as shown in Fig. 6.

In Fig. 6, 61 is an etching chamber, 62 a gas inlet pipe, 63 a vacuum exhausing pipe, 64 a shield plate, 65 an anode, 66 a cathode, 67 a susceptor, 68 an insulator, 69 a substrate to be processed, and 60 a plasma. The abbreviations RF, G, and W indicate a high frequency oscillator (13.56 MHz, for instance), electrical ground, and a water cooling mechanism, respectively.

When the substrate has been placed in the etching system a gas mixture of carbon tetrachloride ($CCl_4$) and boron trichloride ($BCl_3$) is introduced into the etching chamber 61. The content and the flow rate of the mixed gas is controlled to be same as those in an ordinary dry etching of aluminum. Also, the pressure in the etching chamber 61 is maintained to be an ordinary value, by controlling the exhausting rate of the system. An exemplary value for the $CCl_4/BCl_3$ ratio is 1/5 and for the pressure is 13 Pa (0.1 Torr). Then, 13.56 MHz radio frequency power at about 400 W is supplied between the anode 65 and cathode 66.

Under the above conditions, unmasked portions of the aluminum film 510 are subject to a reactive ion etching, and 0.5 to 0.6 micron of the film, equivalent to about a half of the thickness thereof, is etched off, as shown in Fig. 5(C). The time taken for this etching step is about 4 to 5 minutes. The above dry etching step is referred to as a first reactive ion etching.

When the first reactive ion etching has been finished, active chlorine atoms ($Cl^*$) are adsorbed on the surface of the etched portion of the aluminum film 510, and also on the surface of the resist mask film 511.

After the first reactive ion etching, the gas in the etching chamber 61 is replaced by another gas mixture of carbon tetrafluoride ($CF_4$) and oxygen ($O_2$) of a pressure of about 40 Pa (0.3 Torr), (content of the oxygen being about 10 to 20%), for example, then radio frequency power of about 300 W is supplied for about 120 seconds. Thus, a plasma containing active fluorine species is generated, and the surface of the substrate, that is, the surfaces of the resist mask film 511 and unmasked portions of the aluminum film 510 are exposed to the plasma. The addition of $O_2$ to $CF_4$ is for enhancing efficiency of the plasma exposure, because $O_2$ reduces recombination between the fluorine radicals and fragments of $CF_4$, such as $CF_3$, thus increasing the F* radical concentration.

With the exposure to the plasma, chlorine radicals (Cl*) adsorbed on the surfaces of the resist mask film 511 and the aluminum film 510 are removed. Instead, fluorine radicals (F*) are adsorbed on the surface of the resist mask film 511 and etched surface of the aluminum film 510, as shown in Fig. 5(D).

Then, the atmosphere in the etching chamber 61 is switched again to a gas mixture of $CCl_4$ and $BCl_3$ with a pressure of about 13 Pa (0.1 Torr), and a second reactive ion etching is carried out under the same conditions as for the first reactive ion etching. Thus, the remaining half thicknesses of the unmasked portions of the aluminum film 510 are etched off (down to the surface of the $SiO_2$ insulator layer 58), and the aluminum film 510 is delineated in accordance with the pattern of the resist mask film 511, as shown in Fig. 5(E).

As indicated previously, the surface of a side wall, formed in the aluminum film 510 in the course of the first reactive ion etching, is prevented from adsorbing active chlorine atoms (Cl*) during the second reactive ion etching, owing to the layer of the fluorine radicals (F*), which are adsorbed onto the side wall surface during the plasma exposure process. Therefore, the side wall surface is protected from further side etching during the second reactive ion etching.

Furthermore, the adsorption of aluminum chloride ($AlCl_x$) on the surface of the resist mask film 511 during the second reactive ion etching is suppressed by the plasma exposure, as explained below.

After completing the patterning of the aluminum film 510, the substrate is transferred in another plasma exposure system having cylindrical chamber, for example, and its resist mask film 511 removed by exposure to oxygen ($O_2$) plasma. Thus, as shown in Fig. 5(F), wiring patterns 512a, 512b, and 512c of aluminum, contacting the base region 55, emitter region 56, and collector contact region 57, respectively, through respective contact holes 59a, 59b, and 59c, are fabricated.

Though not illustrated in the Figures, after subsequent processes, including formation of a surface protecting insulating layer, etc, are carried out, the manufacture of the bipolar IC is completed.

The reason for the suppression of adsorption of aluminum chloride on the surface of the resist mask film 511 during the second reactive ion etching has not been clear. However, it can be understood to result from the fluorization of the surface of the resist mask film 511 during the plasma exposure process. That is, fluorine radicals from the plasma substitute for the hydrogen atoms on the surface of the resist mask film 511 to form C—F bonds having less ionic properties than C—H bonds. Therefore, probability of the adsorption of ionic molecule like aluminum chloride to the surface on the resist mask film 511 is decreased, and the penetration of the hydrochloric acid into the resist mask film 511 is also prevented. As a result, the corrosion of the aluminum film by the hydrochloric acid, which should be caused when the substrate is exposed in air just after dry etching using a gas containing chlorine species, is reduced.

In a case in which an Al-Si alloy film is used instead of the aluminium film, Si segregated during the first reactive ion etching is removed by the plasma exposure using fluorine containing gas, because etching rate of fluorine radicals to Si is higher than that of chlorine radicals. Accordingly, insufficient electrical isolation due to a residual Si layer or an Al layer covered with the Si layer can be eliminated by introduction of the plasma exposure process step into dry etching.

It is obvious that the plasma exposure process using $CF_4$ and $O_2$ need not be used only once in the course of reactive ion etching as described in the above embodiment. The plasma exposure process may be inserted in the overall reactive ion etching process twice or more. Further, the addition of a plasma exposure process prior to and/or subsequent to a reactive ion etching is effective to enhance the efficacy of a plasma exposure process performed at an intermediate stage during reactive ion etching.

The same effect can be also obtained by plasma exposure processes using other fluorine compound gases than those mentioned above; for example there may be used any of $CHF_3$, $CF_4$, $C_2F_6$, $C_3F_8$, or a mixture of any one of $CHF_3$, $CF_4$, $C_2F_6$, $C_3F_8$ and oxygen or an inert gas.

It will be clear that an embodiment of this invention can be applied to the patterning of an upper side aluminum wiring layer of a multiple wiring structure.

Moreover, embodiments of this invention can be effectively applied to forming a wiring pattern on a layer of Al alloy including Al-Si, Al-Cu, etc.

As described above, an embodiment of this invention can provide means for solving the following problems experienced with previous dry etching techniques for fabricating a wiring layer of aluminum film, including aluminum alloy; that is, decrease of line width due to side etching, corrosion of the wiring layer both of which result in poor operational reliability of devices, and insufficient electrical isolation between wiring layers, due to the presence of a residual silicon or aluminum layer.

Consequently, embodiments of the this invention are effective for enhancing manufacturing yield and reliability of semiconductor devices having high integration density, such as LSIs.

## Claims

1. A process for etching a layer of aluminium or aluminium alloy, the process comprising the following successive steps, carried out in an etching chamber of an etching apparatus:-

a first dry etching step, for removing a part of the thickness of the layer, using a first gas, comprising chlorine or a chlorine compound, in the etching chamber;

exchanging the first gas in the etching chamber for a second gas which comprises fluorine or fluorine compound gas;

an exposure step, in which a layer surface formed in the first dry etching step is exposed to plasma, generated by discharge in the second gas, supplying fluorine free radicals;

exchanging the second gas in the etching chamber for the first gas or for a further gas which comprises chlorine or a chlorine compound;

a further dry etching step, for removing a further part of the thickness of the layer, using the first gas or the further gas.

2. A process as claimed in claim 1, wherein the first and further dry etching steps each involve reactive ion etching.

3. A process as claimed in claim 1 or 2, wherein a plurality of such exposure steps, each followed by such a further dry etching step, are employed.

4. A process as claimed in claim 1, 2 or 3, wherein such an exposure step is additionally provided prior to the first dry etching and/or subsequently to the or the final further dry etching step.

5. A process as claimed in any preceding claim, wherein said second gas includes $CHF_3$, $CF_4$, $C_2F_6$, or $C_3F_8$.

6. A process as claimed in claim 5, wherein said second gas further comprises oxygen.

7. A process as claimed in claim 5, wherein said second gas further comprises an inert gas.

8. A process as claimed in any preceding claim, wherein the fluorine free radicals substitute for chlorine atoms adsorbed on said layer surface during the first dry etching step.

9. A process as claimed in claim 8, wherein a portion of the layer, from which a part of the thickness of the layer is removed in the first dry etching step, and a further part of the thickness removed in the or each further dry etching step, is defined by a resist film formed on the layer, the fluorine free radicals also reacting with the resist film to prevent or reduce formation of hydrochloric acid upon exposure to air after the etching.

**Patentansprüche**

1. Verfahren zum Ätzen einer Schicht aus Aluminium oder Aluminiumlegierung, welches Verfahren die folgenden aufeinander folgenden Schritte umfaßt, durchgeführt in einer Ätzkammer einer Ätzvorrichtung:-

einen ersten Trockenätzschritt, zum Entfernen eines Teils der Dicke der Schicht, unter Verwendung eines ersten Gases, das Chlor oder eine Chlorverbindung umfaßt, in der Ätzkammer;

Austauschen des ersten Gases in der Ätzkammer gegen eine zweites Gas, welches Fluor- oder ein Fluorverbindungsgas umfaßt;

einen Exponierungsschritt, bei welchem eine Schichtoberfläche, die bei dem ersten Trockenätzschritt gebildet wurde, einem Plasma exponiert wird, das durch Entladung in dem zweiten Gas erzeugt wird, wobei fluorfreie Radikale geliefert werden;

Austauschen des zweiten Gases in der Ätzkammer gegen das erste Gas oder gegen ein weiteres Gas, welches Chlor oder eine Chlorverbindung umfaßt;

einen weiteren Trockenätzschritt, zum Entfernen eines weiteren Teils der Dicke der Schicht, unter Vewendung des ersten Gases oder des weiteren Gases.

2. Verfahren nach Anspruch 1, bei dem der erste und der weitere Trockenätzschritt jeweils ein reaktives Ionenätzen umfassen.

3. Verfahren nach Anspruch 2 oder 3, bei dem eine Vielzahl von solchen Exponierungsschritten verwendet werden, jeweils gefolgt von solch einem weiteren Trockenätzschritt.

4. Verfahren nach Anspruch 1, 2 oder 3, bei dem solch ein Exponierungsschritt zusätzlich vorgesehen ist, vor der ersten Trockenätzen und/oder nach dem oder dem letzten weiteren Trockenätzschritten.

5. Verfahren nach einem der vorhergehenden Ansprüche, bei dem das genannte zweite Gas $CHF_3$, $CF_4$, $C_2F_6$ oder $C_3F_8$ enthält.

6. Verfahren nach Anspruch 5, bei dem das genannte zweite Gas ferner Sauerstoff umfaßt.

7. Verfahren nach Anspruch 5, bei dem das genannte zweite Gas ferner ein inertes Gas umfaßt.

8. Verfahren nach einem der vorhergehenden Ansprüche, bei dem die fluorfreien Radikale die Chloratome substituieren, die während des ersten Trockenätzschrittes an der genannten Oberflächenschicht adsorbiert wurden.

9. Verfahren nach Anspruch 8, bei dem ein Abschnitt der Schicht, von der ein Teil der Schichtdicke beim ersten Trockenätzschritt entfernt wurde, und ein weiterer Teil der Dicke bei dem oder jedem weiteren Trockenätzschritt entfernt wird, durch einen Resistfilm begrenzt ist, der auf der Schicht gebildet ist, wobei die fluorfreien Radikale auch mit dem Resistfilm reagieren, um nach dem Ätzen, bei der Berührung mit Luft, die Bildung von Salzsäure zu verhindern oder zu reduzieren.

**Revendications**

1. Procédé d'attaque d'une couche d'aluminium ou d'alliage d'aluminium, comprenant les étapes successives suivantes, exécutées dans une chambre d'attaque d'un appareil d'attaque:

—une première étape d'attaque à sec destinée à retirer une partie de l'épaisseur de la couche, à l'aide d'un premier gaz contenant du chlore ou un composé du chlore, dans la chambre d'attaque,

—le remplacement du premier gaz, dans la chambre d'attaque, par un second gaz qui contient du fluor ou un composé du fluor à l'état gazeux,

—une étape d'exposition au cours de laquelle la surface d'une couche formée dans la première étape d'attaque à sec est exposée à un plasma créé par décharge dans le second gaz, avec formation de radicaux libres fluor,

—le remplacement du second gaz, dans la chambre d'attaque, par le premier gaz ou par un autre gaz qui contient du chlore ou un composé du chlore, et

—une étape supplémentaire d'attaque à sec destinée à retirer une partie supplémentaire de l'épaisseur de la couche à l'aide du premier gaz ou du gaz supplémentaire.

2. Procédé selon la revendication 1, dans lequel la première étape d'attaque à sec et l'étape supplémentaire d'attaque à sec mettent en oeuvre toutes deux une attaque par des ions réactifs.

3. Procédé selon la revendication 1 ou 2, dans lequel plusieurs étapes d'exposition sont utilisées, chacune d'elle étant suivie par une étape supplémentaire d'attaque à sec.

4. Procédé selon la revendication 1, 2 ou 3, dans lequel l'étape d'exposition est en outre utilisée avant la première attaque à sec et/ou après l'étape supplémentaire d'attaque à sec ou l'étape finale supplémentaire d'attaque à sec.

5. Procédé selon l'une quelconque des revendications précédentes, dans lequel le second gaz contient $CHF_3$, $CF_4$, $C_2F_6$ ou $C_3F_8$.

6. Procédé selon la revendication 5, dans lequel le second gaz contient en outre de l'oxygène.

7. Procédé selon la revendication 5, dans lequel le second gaz contient en outre un gaz inerte.

8. Procédé selon l'une quelconque des revendications précédentes, dans lequel les radicaux libres fluor remplacent les atomes de chlore adsorbés sur la surface de la couche formée pendant la première étape d'attaque à sec.

9. Procédé selon la revendication 8, dans lequel une partie de la couche, dont une partie de l'épaisseur est retirée dans la première étape d'attaque à sec et une partie supplémentaire de l'épaisseur est retirée dans l'étape supplémentaire ou chaque étape supplémentaire d'attaque à sec, est délimitée par un film d'une matière de réserve formé sur la couche, les radicaux libres fluor réagissant aussi avec le film de la matière de réserve en empêchant ou en réduisant la formation d'acide chlorhydrique lors de l'exposition à l'air après l'attaque.

FIG. 1

$Cl^+, CCl_3^+, Cl^*$ ¼

$AlCl_x$    $AlCl_x$    3

$Cl^*$    1

2

FIG. 2

1

FIG. 3

3

31    32

2

FIG. 4 (A)

$F^+$, $CF_3^+$, $F^*$   2/4

$AlCl_x$

$Cl^*$   $Cl^*$

$F^*$

43

41

42

$Cl^+$, $CCl_3^+$, $Cl^*$

FIG. 4 (B)

$F^*$   $AlCl_x$   $AlCl_x$

$Cl^*$

43

41

42

$d_1$

$d_2$

FIG. .5

(A)

(B)

$Cl^+$, $CCl_3^+$, $BCl_2^+$, $Cl^*$

(C)

$F^+$, $CF_3^+$, $F^*$, $O_2^+$

(D)

FIG. 5
(Continued)

$Cl^+, CCl_3^+, BCl_2^+, Cl^*$

(E)

(F)

FIG. 6

W

RF

G

4